# EUROPEAN PATENT APPLICATION

(11) **EP 4 565 049 A1**
(43) Date of publication of application: **04.06.2025**
(21) Application number: 24216302.0
(22) Date of filing: 28.11.2024
(51) Int. Cl.: H10K 59/80, H10K 77/10

(54) **DISPLAY APPARATUS INCLUDING A BENDING AREA**

(30) Priority: 28.11.2023 KR 20230168243
(71) Applicant: Samsung Display Co., Ltd., Yongin-si, Gyeonggi-do 17113 (KR)
(72) Inventor: Kim, Gangmin, 17113 Yongin-si (KR); Kim, Dohyeon, 17113 Yongin-si (KR); Namkung, Jun, 17113 Yongin-si (KR); Lee, Kwangrae, 17113 Yongin-si (KR)
(74) Representative: Taor, Simon Edward William

(57) **Abstract**

A display apparatus includes a display module including a bending area, a first non-bending area, and a second non-bending area, the first non-bending area and the second non-bending area being spaced apart from each other with the bending area interposed therebetween. A display driver is disposed in the second non-bending area, a stiffener is disposed in the second non-bending area and is adjacent to the display driver, and an adhesive is disposed in the second non-bending area and on a lower surface of the stiffener. The display module includes a display panel including a display element, a touch unit disposed on the display panel and including a touch electrode and a signal line, and a planarization layer disposed on the touch unit. The planarization layer is disposed in the first non-bending area and extends from the first non-bending area to the second non-bending area.

## Description

### CROSS-REFERENCE TO RELATED APPLICATION

The present application claims priority under 35 U.S.C. §119 to Korean Patent Application No. 10-2023-0168243, filed on November 28, 2023, in the Korean Intellectual Property Office.

### TECHNICAL FIELD

The present disclosure relates to a display apparatus, and more particularly, to a display apparatus including a bending area.

### DISCUSSION OF THE RELATED ART

Mobile electronic devices have become widely used. In addition to small electronic devices such as mobile phones, tablet computers and related devices have recently become broadly used as mobile electronic devices. Such mobile electronic devices include displays in order to provide various functions to a user, for example, to display visual information such as an image or a video.

As various components for driving a display apparatus have been miniaturized, the importance of the display apparatus for an electronic device has increased. Thus, a structure in which a display apparatus is bent to a certain angle, with respect to a flat state, or folded, with respect to a bending axis, has been developed.

In general, a display apparatus includes a display area displaying an image and a peripheral area which is a non-display area adjacent to the display area. In a display panel, as described above, at least a portion of the peripheral area may be bent, and thus, visibility of the display apparatus from various angles may be increased or an area of the non-display area may be reduced.

### SUMMARY

A display apparatus includes a display module including a bending area, a first non-bending area, and a second non-bending area, the first non-bending area and the second non-bending area being spaced apart from each other with the bending area interposed therebetween. A display driver is disposed in the second non-bending area. A stiffener is disposed in the second non-bending area and is adjacent to the display driver. An adhesive is disposed in the second non-bending area and on a lower surface of the stiffener. The display module includes a display panel including a display element, a touch unit disposed on the display panel and including a touch electrode and a signal line, and a planarization layer disposed on the touch unit, and the planarization layer is disposed in the first non-bending area and extends from the first non-bending area to the second non-bending area.

A portion of the planarization layer may be disposed in the bending area.

The touch electrode of the touch unit may be disposed in the first non-bending area and a portion of the signal line may be disposed in the bending area, and the planarization layer may overlap the portion of the signal line disposed in the bending area.

The first non-bending area may include a display area in which the display element is disposed and a first peripheral area disposed outside of the display area, and the planarization layer may be disposed in the display area and the first peripheral area.

The display panel may include a first dam portion disposed in the first peripheral area and a second dam portion disposed in at least the second non-bending area.

A portion of the second dam portion may overlap the stiffener.

The planarization layer may be disposed at an inner side of the second dam portion.

The second dam portion may be disposed in the first peripheral area, the bending area, and the second non-bending area and may be disposed at an outer side of the first dam portion.

The display panel may further include a substrate, a pixel circuit layer disposed on the substrate and including a pixel circuit, a light-emitting device disposed on the pixel circuit layer, and an encapsulation structure disposed on the light-emitting device and including at least one inorganic encapsulation layer and at least one organic encapsulation layer, and the at least one organic encapsulation layer may be disposed at an inner side of the first dam portion.

The planarization layer may overlap a portion of the stiffener.

The planarization layer may overlap a portion of the adhesive.

The planarization layer may be in contact with a side surface of the adhesive.

The display apparatus may further include a bending protection layer disposed on the planarization layer in the bending area.

The adhesive may be in contact with the bending protection layer.

The display apparatus may further include a cover disposed on the display driver and the stiffener in the second non-bending area.

The stiffener may surround a portion of the display driver in a plan view.

A display apparatus includes a display module including a bending area, a first non-bending area, and a second non-bending area, the first non-bending area and the second non-bending being spaced apart from each other with the bending area interposed therebetween. A display driver is disposed in the second non-bending area, and a stiffener is disposed in the second non-bending area and is adjacent to the display driver. The display module includes a display panel and a planarization layer. The display panel includes a light-emitting device and an encapsulation structure encapsulating the light-emitting device, and the planarization layer is disposed on the display panel. The first non-bending area includes a display area in which the light-emitting device is disposed and a first peripheral area disposed outside of the display area, and the planarization layer is disposed in the display area and the first peripheral area and overlaps the bending area.

The planarization layer may overlap a portion of the stiffener.

The display apparatus may further include a bending protection layer disposed on the planarization layer in the bending area.

The display panel may include a first dam portion disposed in the first peripheral area and a second dam portion disposed in at least the second non-bending area.

A portion of the second dam portion may overlap the stiffener.

A display apparatus includes a display module including a bending area, a first non-bending area, and a second non-bending area. The first non-bending area and the second non-bending area spaced apart from each other with the bending area interposed therebetween. A display driver is disposed in the second non-bending area, a stiffener is disposed in the second non-bending area and is adjacent to the display driver, an adhesive is disposed between the stiffener and the display module, and a bending protection layer is disposed in the bending area. The bending protection layer is in contact with the adhesive.

An area of the adhesive may be greater than an area of the stiffener.

The adhesive may include a first portion overlapping the stiffener and a second portion that does not overlap the stiffener.

The display apparatus may further include a protection layer that may be disposed on the second portion of the adhesive.

The display apparatus may further include a cover disposed on the display driver and the stiffener may be disposed in the second non-bending area. The cover may overlap the second portion.

An electronic device may include the display apparatus.

According to an aspect, there is provided a display apparatus as set out in claim 1. Additional features are set out in claims 2 to 10.

According to an aspect, there is provided a display apparatus as set out in claim 11. Additional features are set out in claim 12.

According to an aspect, there is provided a display apparatus as set out in claim 13. Additional features are set out in claims 14 and 15.

### BRIEF DESCRIPTION OF THE DRAWINGS

The above and other aspects and features of embodiments of the disclosure will be more apparent from the following description taken in conjunction with the accompanying drawings, in which:
FIG. 1 is a schematic plan view of a display apparatus according to an embodiment;
FIG. 2 is a schematic plan view of a display module included in a display apparatus according to an embodiment;
FIG. 3 is a schematic plan view of a display panel according to an embodiment;
FIG. 4 is a schematic plan view of a touch unit according to an embodiment;
FIG. 5A is a schematic cross-sectional view of a portion of a display apparatus according to an embodiment;
FIG. 5B is a schematic cross-sectional view showing a bent shape of a display module of the display apparatus of FIG. 5A;
FIG. 6 is a schematic cross-sectional view of a portion of a display apparatus according to an embodiment;
FIG. 7 is a schematic cross-sectional view of a portion of a display apparatus according to an embodiment;
FIG. 8 is a schematic cross-sectional view of a portion of a display apparatus according to an embodiment;
FIG. 9 is a schematic cross-sectional view of a portion of a display apparatus according to an embodiment;
FIG. 10 is a schematic cross-sectional view of a portion of a display apparatus in a display area, according to an embodiment;
FIG. 11 is a schematic cross-sectional view of a portion of a display apparatus in a peripheral area, according to an embodiment; and
FIG. 12 is a schematic cross-sectional view of a portion of a display apparatus according to an embodiment.

### DETAILED DESCRIPTION

Reference will now be made in detail to embodiments, examples of which are illustrated in the accompanying drawings, wherein like reference numerals refer to like elements throughout the figures and the drawings. In this regard, the present embodiments may have different forms and should not necessarily be construed as being limited to the descriptions set forth herein. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

Hereinafter, embodiments will be described in detail by referring to the accompanying drawings. In descriptions with reference to the drawings, the same reference numerals may be given to elements that are the same or substantially the same and to the extent that an element is not described in detail with respect to this figure, it may be understood that the element is at least similar to a corresponding element that has been described elsewhere within the present disclosure.

In the embodiments described hereinafter, the terms "first," "second," etc. are used to distinguish an element from another and are not necessarily used as a restrictive sense.

As used herein, the singular expressions "a," "an," and "the" are intended to include the plural forms as well, unless the context clearly indicates otherwise.

It will be further understood that the terms "comprises" and/or "comprising" used herein specify the presence of stated features or elements, but do not preclude the presence or addition of one or more other features or elements.

It will be understood that when a layer, region, or element is referred to as being formed "on" another layer, area, or element, it can be directly or indirectly formed on the other layer, region, or element. For example, for example, intervening layers, regions, or elements may be present.

While each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the scope of the present disclosure, for example, to allow for manufacturing limitations and the like.

When a certain embodiment may be implemented differently, a specific process order may be performed differently from the described order. For example, two consecutively described processes may be performed substantially at the same time or performed in an order opposite to the described order.

In this specification, the expression "A and/or B" may indicate A, B, or A and B. Also, the expression "at least one of A and B" may indicate A, B, or A and B.

In the embodiments hereinafter, it will be understood that when an element, an area, or a layer is referred to as being connected to another element, area, or layer, it can be directly and/or indirectly connected to the other element, area, or layer. For example, it will be understood in this specification that when an element, an area, or a layer is referred to as being in contact with or being electrically connected to another element, area, or layer, it can be directly and/or indirectly in contact with or electrically connected to the other element, area, or layer.

An x-axis direction, a y-axis direction and a z-axis direction are not necessarily limited to directions corresponding to three axes of the rectangular coordinate system, and may be interpreted in a broader sense. For example, the x-axis direction, the y-axis direction, and the z-axis direction may be perpendicular to one another, or may represent different directions that are not perpendicular to one another.

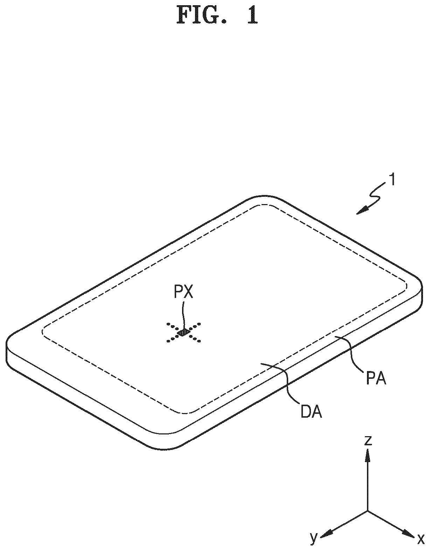

FIG. 1 is a schematic plan view of a display apparatus 1 according to an embodiment.

Referring to FIG. 1, the display apparatus 1 may include a display area DA and a peripheral area PA outside of the display area DA. The display apparatus 1 may provide an image through an array of a plurality of pixels PX that are two-dimensionally arranged in rows and columns in the display area DA. The pixel PX may include a pixel circuit and a light-emitting device driven by the pixel circuit. An image may be provided by light emitted by the light-emitting device of the pixel PX. An area providing an image may be determined according to arrangement of a plurality of light-emitting devices, and thus, the display area DA may be defined by the plurality of light-emitting devices. In the display area DA, not only the light-emitting devices and the pixel circuits, but also various signal lines, power lines, etc. electrically connected to the pixel circuits may be disposed.

The peripheral area PA is an area which might not provide an image and may entirely or partially surround the display area DA. In the peripheral area PA, various lines, driving circuits, etc. configured to provide an electrical signal or a power supply to the display area DA may be disposed.

The display apparatus 1 may have an approximately rectangular shape, when viewed in a direction perpendicular to a surface of the display apparatus 1. For example, the display apparatus 1 may generally have a planar rectangular shape having a pair of short side extending in a first direction (for example, an x-axis direction) and a pair of long side extending in a second direction (for example, a y-axis direction) as illustrated in FIG. 1. A corner at which the short side in the first direction and the long side in the second direction meet each other may have a rectangular shape or, as illustrated in FIG. 1, a round shape having a certain curvature. However, the planar shape of the display apparatus 1 is not necessarily limited to the rectangular shape and may have various shapes, such as a polygonal shape including a triangular shape, a circular shape, an oval shape, an amorphous shape, and the like.

An electronic device may include the display apparatus 1. For example, the electronic device may be a portable electronic device, wearable device, a television, a laptop/notebook computer, a computer monitor, an advertising billboard, an Internet of things (IOT) device, or an automotive electronic device. The display apparatus 1 may be used as a display screen of not only portable electronic devices, such as a mobile phone, a smartphone, a tablet computer, a mobile communication terminal, an electronic notebook, an electronic book, a portable multimedia player (PMP), a navigation device, an ultra-mobile PC (UMPC), etc., but also of various products, such as a television, a laptop/notebook computer, a computer monitor, an advertising billboard, an Internet of things (IOT) device, etc. Also, the display apparatus 1, according to an embodiment, may be used in wearable devices, such as a smart watch, a watch phone, a glasses-type display, and a head-mounted display (HMD). Also, the display apparatus 1, according to an embodiment, may be used as: a center information display (CID) on a gauge of a vehicle or a center fascia or a dashboard of the vehicle; a room mirror display substituting a side-view mirror of a vehicle; or a display screen disposed on a rear surface of a front seat, as an entertainment device for a backseat of a vehicle. Hereinafter, a case in which the display apparatus 1 is used in a smartphone is described, for convenience of explanation.

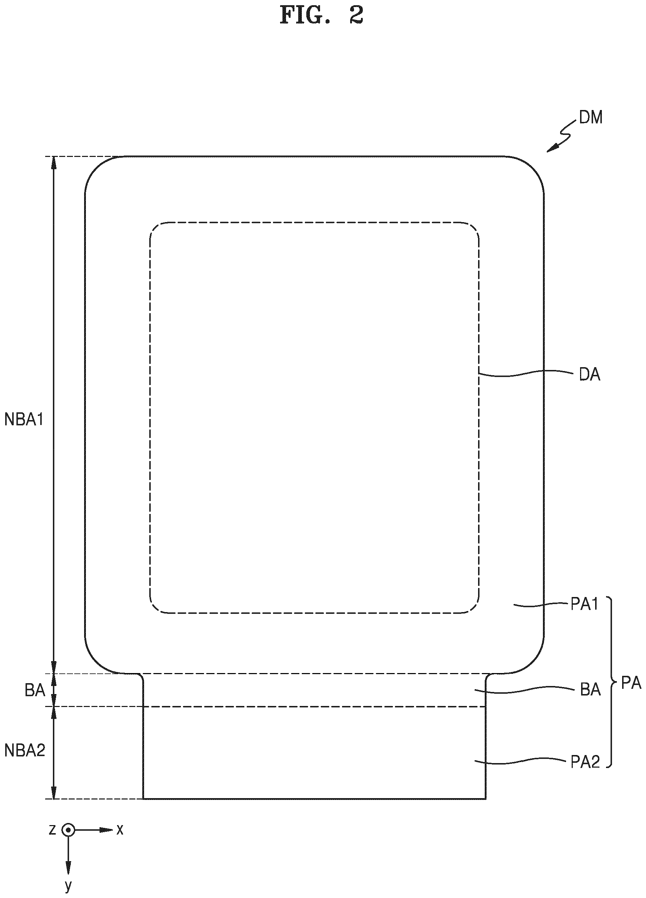

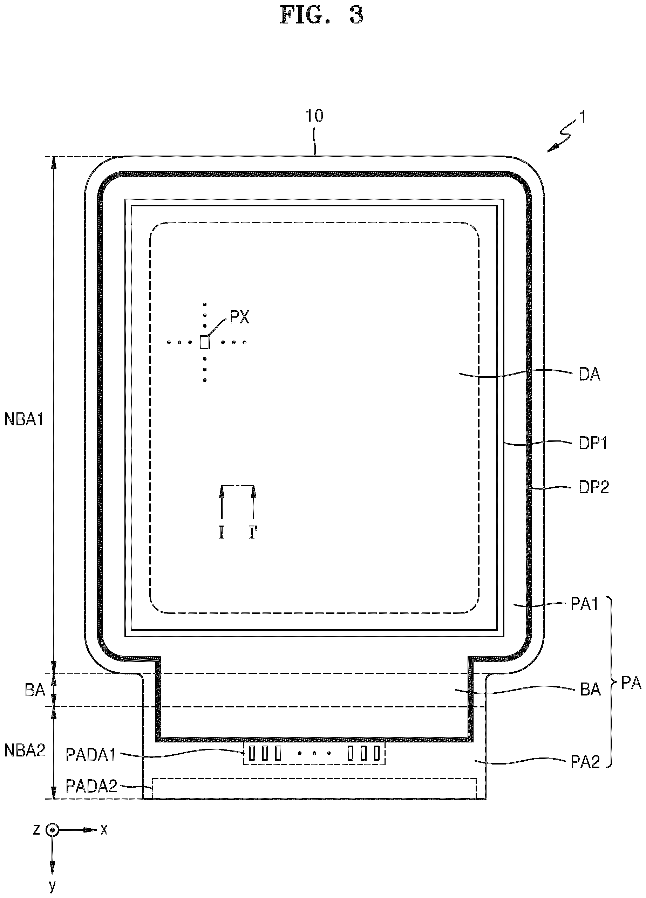

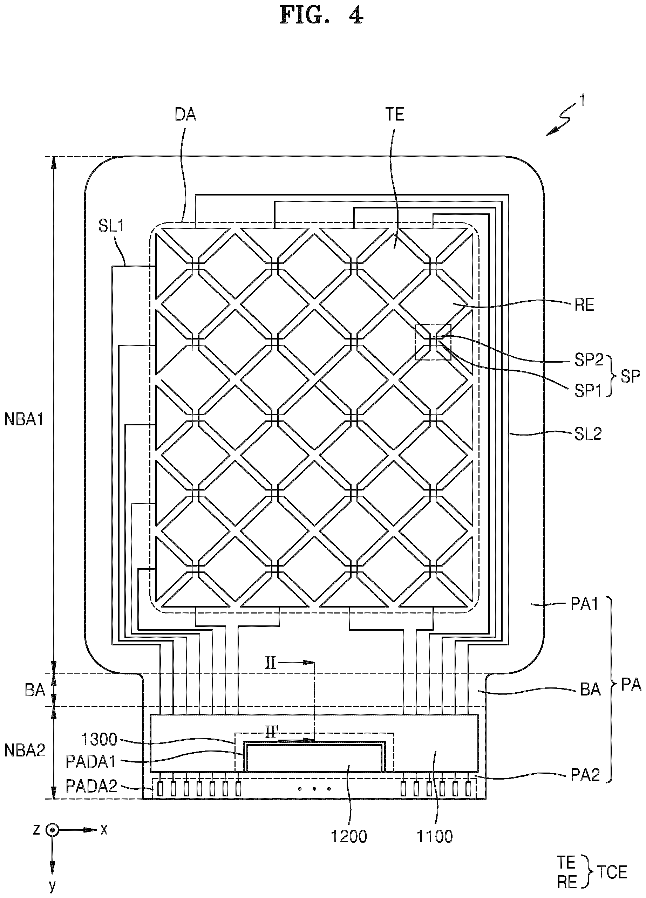

FIG. 2 is a schematic plan view of a display module DM included in the display apparatus 1, according to an embodiment. FIG. 3 is a schematic plan view of a display panel 100 of the display apparatus 1, according to an embodiment. FIG. 4 is a schematic plan view of a touch unit 200 of the display apparatus 1, according to an embodiment.

The display apparatus 1 of FIG. 1 may include the display module DM described with reference to FIGS. 2 to 4. The display module DM of FIG. 2 may include the display panel 100 of FIG. 3 and the touch unit 200 of FIG. 4.

Referring to FIGS. 2 to 4, the display module DM may include a bending area BA and a first non-bending area NBA1 and a second non-bending area NBA2 that are adjacent to the bending area BA. The display module DM may include the first non-bending area NBA1 and a second non-bending area NBA2 spaced apart from each other with the bending area BA. The second non-bending area NBA2 may be spaced apart from the first non-bending area NBA1 with the bending area BA therebetween in the second direction (for example, the y-axis direction) The first non-bending area NBA1, the bending area BA, and the second non-bending area NBA2 may be sequentially arranged in the second direction (for example, the y-axis direction).

The display module DM may include a display area DA and a peripheral area PA surrounding at least a portion of the display area DA. The display area DA of the display module DM may correspond to a display area DA of the display apparatus 1 described above with reference to FIG. 1. Hereinafter, for convenience of explanation, a case where the peripheral area PA entirely surrounds the display area DA as illustrated in FIG. 2 will be described.

According to an embodiment, the peripheral area PA may include a first peripheral area PA1 disposed outside of the display area DA, a second peripheral area PA2 disposed at a side of the first peripheral area PA1, and a bending area BA between the first peripheral area PA1 and the second peripheral area PA2. Together with the display area DA, the first peripheral area PA1 may form a front surface of the display module DM. The front surface of the display module DM may be a surface on which an image is displayed. The first peripheral area PA1 and the display area DA may correspond to the first non-bending area NBA1. For example, the first non-bending area NBA1 may include the first peripheral area PA1 and the display area DA. The second peripheral area PA2 may correspond to the second non-bending area NBA2.

The display module DM may be a flexible display module having flexibility and easily bent, folded, or rolled. For example, the display module DM may include a foldable display module which may be folded or unfolded, a curved display module, a display surface of which has at least a curved portion, a bent display module in which an area other than a display surface is bent, a rollable display module which may be rolled or unrolled, or a stretchable display module which may be stretched.

As illustrated in FIG. 3, the display panel 100 may include a substrate 10, and various components included in the display panel 100 may be disposed on the substrate 10. For example, a plurality of light-emitting devices defining the display area DA, pixel circuits configured to drive each of the light-emitting devices, signal lines and/or voltage lines configured to provide electrical signals and/or voltages to each of the pixel circuits, and driving circuits may be disposed on the substrate 10.

The display panel 100 may include the pixel PX disposed in the display area DA. For example, the display panel 100 may include the pixel circuit and the light-emitting device electrically connected to the pixel circuit in the display area DA.

The display panel 100 may include a first dam portion DP1 and a second dam portion DP2. The first dam portion DP1 and the second dam portion DP2 may be disposed in the peripheral area PA. The first dam portion DP1 and the second dam portion DP2 may be spaced apart from each other.

The first dam portion DP1 may be disposed in the first peripheral area PA1. For example, the first dam portion DP1 may be disposed in the first non-bending area NBA1. The first dam portion DP1 may surround at least a portion of the display area DA.

The second dam portion DP2 may be disposed outside of the first dam portion DP1. For example, the second dam portion DP2 may surround at least a portion of the first dam portion DP1 but is not necessarily limited thereto. The second dam portion DP2 may be disposed in at least the second non-bending area NBA2. For example, the second dam portion DP2 may be disposed in at least the second non-bending area NBA2 to be adjacent to a stiffener 1100 described below. For example, as illustrated in FIG. 3, the second dam portion DP2 may be disposed in the first non-bending area NBA1, the bending area BA, and the second non-bending area NBA2. For example, as illustrated in FIG. 3, the second dam portion DP2 may be disposed in the first peripheral area PA1, the bending area BA, and the second non-bending area NBA2.

In the embodiment, two dam portions surrounding the display area DA are illustrated. However, an embodiment is not necessarily limited thereto, and the number of dam portions may be one or two and may be variously modified.

As illustrated in FIGS. 3 and 4, the second peripheral area PA2 may include a first pad area PADA1 and a second pad area PADA2, in each of which a plurality of pads are disposed.

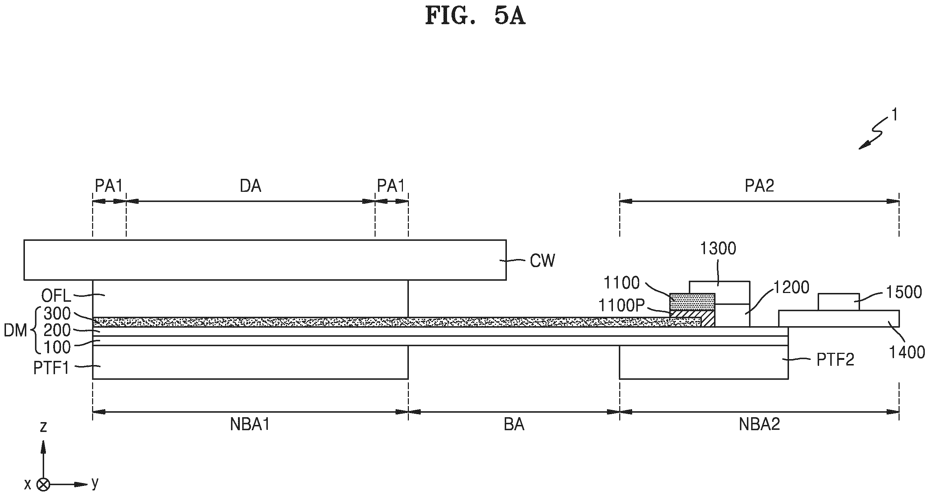

A display driver 1200 may be disposed in the first pad area PADA1 of the display module DM as illustrated in FIG. 4. The display driver 1200 might not overlap first and second signal lines SL1 and SL2 described below. A circuit board 1400 (see FIG. 5A) described below may be disposed in the second pad area PADA2 of the display module DM.

The display driver 1200 and a stiffener 1100 adjacent to the display driver 1200 may be disposed in the second peripheral area PA2 (or the second non-bending area NBA2). According to an embodiment, the stiffener 1100 may surround a portion of the display driver 1200, in a plan view. In the second peripheral area PA2 (or the second non-bending area NBA2), a cover 1300 may be disposed on portions of the display driver 1200 and the stiffener 1100. In a plan view, an area of the cover 1300 may be greater than an area of the display driver 1200.

FIG. 4 illustrates the touch unit 200 configured to operate by forming an electrical signal in response to a user's touch. The touch unit 200 may be disposed on the display panel 100. The touch unit 200 may be integrally provided with the display panel 100 as being equipped in the display panel 100 or may be bonded on the display panel 100 as an additional panel by using an adhesive.

FIG. 4 illustrates the touch unit 200 of an electrostatic capacitive type, but it is only an example. According to an embodiment, the touch unit 200 of at least one type selected from among a resistive type, an electro-magnetic type, a surface acoustic wave type, a saw type, and an infrared type may be implemented.

The touch unit 200 may include a plurality of touch electrodes TCE. The touch electrodes TCE may be disposed in the first non-bending area NBA1. The touch electrodes TCE may be disposed in the display area DA. The plurality of touch electrodes TCE may be electrically connected to each other through connection patterns SP. The first and second signal lines SL1 and SL2 connecting the plurality of touch electrodes TCE to an external touch driver through the second pad area PADA2 may further be provided in an external area of the plurality of touch electrodes TCE.

The plurality of touch electrodes TCE may include driving electrodes TE connected to each other in a first direction (for example, an x-axis direction) and sensing electrodes RE distributed between the driving electrodes TE so as not to overlap the driving electrodes TE and connected to each other in a second direction (for example, a y-axis direction) perpendicular to the first direction (for example, the x-axis direction). The driving electrodes TE and the sensing electrodes RE may be alternately arranged in the distributed manner so as not to overlap each other.

The first direction (for example, the x-axis direction) in which the driving electrodes TE are connected to each other and the second direction (for example, the y-axis direction) in which the sensing electrodes RE are connected to each other may be different directions crossing each other. For example, when the first direction (for example, the x-axis direction) is set to be a row direction, the second direction (for example, the y-axis direction) may be set to be a column direction.

For example, the driving electrodes TE may be disposed in a plural number along each of column lines and/or each of row lines, and the driving electrodes TE located in the same column line or the row line (in the embodiment, the same row line) may be connected to each other in the first direction (for example, the x-axis direction) by first connection patterns SP1 disposed in a plural number along the same column line or the same row line. The driving electrodes TE in each line may be connected to the first signal line SL1 corresponding to the driving electrodes TE. The first signal line SL1 may be configured to transmit a touch driving signal applied from an external touch driver to the driving electrodes TE of the touch unit 200. For example, the touch driving signal may be applied to the driving electrodes TE through the first signal lines SL1.

The sensing electrodes RE may be disposed in a plural number along each of row lines and/or each of column lines, and the sensing electrodes RE located in the same row line or the column line (in the embodiment, the same column line) may be connected to each other in the second direction (for example, the y-axis direction) by second connection patterns SP2 disposed in a plural number along the same row line or the same column line. The sensing electrodes RE in each line may be connected to the second signal line SL2 corresponding to the sensing electrodes RE. The second signal line SL2 may be configured to transmit a touch sensing signal to the external touch driver. For example, the touch driver may be electrically connected to the sensing electrodes RE through the second signal lines SL2 and may receive the touch sensing signal from the sensing electrodes RE.

Some of the first signal lines SL1 may be disposed in the first non-bending area NBA1, others of the first signal lines SL1 may be disposed in the bending area BA, and others of the first signal lines SL1 may be disposed in the second non-bending area NBA2. Some of the second signal lines SL2 may be disposed in the first non-bending area NBA1, others of the second signal lines SL2 may be disposed in the bending area BA, and others of the second signal lines SL2 may be disposed in the second non-bending area NBA2.

The touch electrodes TCE may be transparent to have a certain transmittance of visible light so as to transmit light from the display panel 100 disposed therebelow. For example, the touch electrodes TCE may include a transparent electrode layer including at least a transparent electrode material, such as indium tin oxide (ITO).

The connection patterns SP may include the plurality of first connection patterns SP1 formed in plural in the first direction (for example, the x-axis direction) and connecting the driving electrodes TE to each other in the first direction (for example, the x-axis direction) and the plurality of second connection patterns SP2 formed in plural in the second direction (for example, the y-axis direction) and connecting the sensing electrodes RE to each other in the second direction (for example, the y-axis direction). The connection patterns SP may include a transparent electrode material or a non-transparent low-resistance electrode material, while a thickness, a width, etc. thereof may be adjusted to prevent the obvious visibility thereof.

The first signal line SL1 and the second signal line SL2 may be respectively electrically connected to the driving electrodes TE and the sensing electrodes RE in each line, the driving electrodes TE being connected to each other in the first direction (for example, the x-axis direction) and the sensing electrodes RE being connected to each other in the second direction (for example, the y-axis direction), and the first signal line SL1 and the second signal line SL2 may respectively connect the driving electrodes TE and the sensing electrodes RE to the external touch driver through the second pad area PADA2. The first and second signal lines SL1 and SL2 may be located in the peripheral area PA defined outside of the display area DA in which an image is displayed and may include materials in a wide range, for example, low-resistance materials such as Mo, Ag, Ti, Cu, Al, Mo/Al/Mo, etc. in addition to the transparent electrode material used for forming the touch electrodes TCE.

FIG. 4 illustrates that the first and second connection patterns SP1 and SP2 cross each other according to an embodiment. However, embodiments of the disclosure are not necessarily limited thereto. For example, the first connection patterns SP1 may connect the driving electrodes TE to each other in the first direction while not crossing the second connection patterns SP2 by detouring along a path overlapping the adjacent sensing electrodes RE. In this case, an insulating layer for obtaining stability may be disposed between the first connection patterns SP1 and the sensing electrodes RE.

The touch unit 200 having the structure as described above may measure a capacitance changing between the driving electrodes TE and the sensing electrodes RE, when an input device, such as a finger, approaches or contacts the touch unit 200, and thus, may detect a touch position.

Each of the plurality of driving electrodes TE and the plurality of sensing electrodes RE may be a structure in which a plurality of consecutive polygons having a diamond shape are connected, but is not necessarily limited thereto. Shapes, sizes, or arrangement forms of the plurality of driving electrodes TE and the plurality of sensing electrodes RE may be variously changed according to, for example, a shape or a size of a display area DA in which a pixel is disposed or a sensing method.

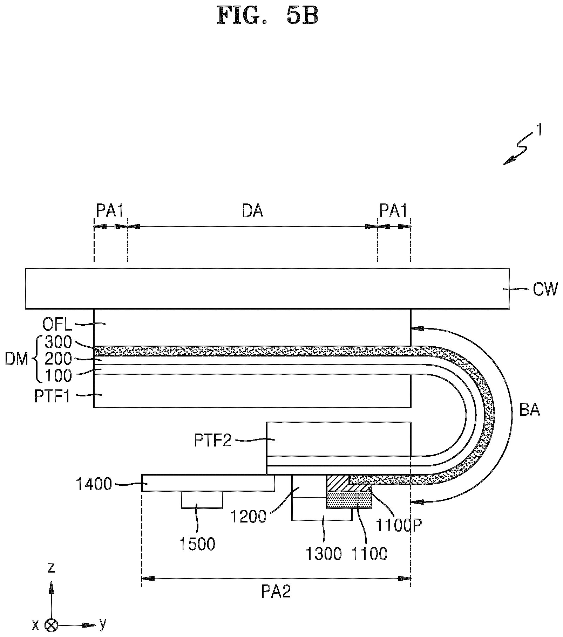

FIG. 5A is a schematic cross-sectional view of a portion of the display apparatus 1 according to an embodiment. FIG. 5B is a schematic cross-sectional view of a shape in which the display module DM of the display apparatus 1 of FIG. 5A is bent.

Referring to FIGS. 5A and 5B, the display apparatus 1 may include the display module DM, an optical functional layer OFL, a cover window CW, the stiffener 1100, the display driver 1200, a circuit board 1400, a touch driver 1500, a first protection film PTF1, and a second protection film PTF2.

The display module DM may display information processed by the display apparatus 1. For example, the display module DM may display execution screen information of an application driven by the display apparatus 1 or user interface (UI) or graphics user interface (GUI) information according to the execution screen information.

The optical functional layer OFL may be disposed on the display module DM. The optical function layer OFL may reduce a reflectivity of light (external light) incident from the outside toward the display apparatus 1 and/or increase the color purity of light emitted from the display apparatus 1. According to an embodiment, the optical functional layer OFL may include a phase retarder and a polarizer. The phase retarder may include a film-type phase retarder or a liquid crystal coating-type phase retarder, and may include a λ/2 phase retarder (i.e., a half-wave plate) and/or a λ/4 phase retarder (i.e., a quarter-wave plate). The polarizer may also include a film-type polarizer or a liquid crystal coating-type polarizer. The film-type polarizer may include an elongation-type synthetic resin film, and the liquid crystal coating-type polarizer may include liquid crystals arranged in a certain shape. The phase retarder and the polarizer may further include a protective film.

According to an embodiment, the optical functional layer OFL may include a black matrix and color filters. The color filters may be arranged by taking into account a color of light emitted from each of pixels in the display apparatus 1. Each of the color filters may include a red, green, or blue pigment or dye. Alternatively, each of the color filters may further include quantum dots, in addition to the pigment or the dye described above. Alternatively, some of the color filters might not include the pigment or the dye described above and may include scattered particles, such as oxide titanium.

According to an embodiment, the optical functional layer OFL may include a destructive interference structure. The destructive interference structure may include a first reflective layer and a second reflective layer disposed on different layers from each other. First reflective light and second reflective light reflected from the first reflective layer and the second reflective layer, respectively, may destructively interfere, and thus, the reflectivity of external light may be decreased.

The cover window CW may be disposed on the optical functional layer OFL. The cover window CW may protect the display module DM. According to an embodiment, the cover window CW may include a flexible window. The cover window CW may protect the display module DM by being easily bent according to an external force without cracks, etc. being generated. The cover window CW may include glass, sapphire, and/or plastic. The cover window CW may include, for example, ultra-thin glass (UTG) or colorless polyimide (CPI). According to an embodiment, the cover window CW may have a structure in which a flexible polymer layer is disposed on a surface of a glass substrate or may have a structure including only a polymer layer.

The display driver 1200 may be disposed in the second non-bending area NBA2. The display driver 1200 may be spaced apart from the first non-bending area NBA1 with the bending area BA interposed therebetween. The display driver 1200 may be spaced apart from the display area DA with the bending area BA interposed therebetween. The display driver 1200 may receive control signals and power voltages and may generate and output signals and voltages to drive the display panel 100. The display driver 1200 may include an integrated circuit (IC).

The stiffener 1100 may be disposed in the second non-bending area NBA2. The stiffener 1100 may be spaced apart from the first non-bending area NBA1 with the bending area BA interposed therebetween. The stiffener 1100 may be spaced apart from the display area DA with the bending area BA interposed therebetween. The stiffener 1100 may be adjacent to the display driver 1200. The stiffener 1100 may protect the components of the display apparatus 1 from external stress. For example, the stiffener 1100 may include stainless steel. For example, the stiffener 1100 may include an alloy of iron and/or chromium.

The display apparatus 1 may further include an adhesive 1100P for bonding the stiffener 1100 to the display module DM. The adhesive 1100P may be disposed in the second non-bending area NBA2. The adhesive 1100P may be disposed on a lower surface of the stiffener 1100. The adhesive 1100P may be disposed between the stiffener 1100 and the display module DM. According to an embodiment, it is illustrated that the adhesive 1100P may be disposed between the stiffener 1100 and the display module DM and the entire adhesive 1100P may overlap the stiffener 1100. However, embodiments of the disclosure are not necessarily limited thereto. For example, the adhesive 1100P and the stiffener 1100 may have the same or substantially the same area as each other but are not necessarily limited thereto. According to an embodiment, a shape or an area of the adhesive 1100P may be variously changed. The adhesive 1100P may be disposed on a portion of a planarization layer 300.

General adhesives known in the art may be implemented as the adhesive 1100P, without particular limitations. For example, the adhesive 1100P may include an optically clear adhesive (OCA) or a pressure sensitive adhesive (PSA).

The display apparatus 1 may further include the cover 1300 disposed on portions of the display driver 1200 and the stiffener 1100. The cover 1300 may be disposed in the second non-bending area NBA2. The cover 1300 may include an antistatic agent. The cover 1300 may cover an upper surface of the display driver 1200.

The circuit board 1400 may be electrically connected to the display panel 100. For example, the circuit board 1400 may be electrically connected to the second pad area PADA2 described with reference to FIG. 4 by an anisotropic conductive film.

The circuit board 1400 may include a flexible printed circuit board (FPCB) which may be bent or a rigid printed circuit board (PCB) which is rigid and not easily bent. Alternatively, according to a case, the circuit board 1400 may include a complex printed circuit board including both of a PCB and an FPCB.

The display apparatus 1 may further include the touch driver 1500 disposed on the circuit board 1400. The touch driver 1500 may include an integrated circuit. The touch driver 1500 may be bonded on the circuit board 1400 or may be equipped in the circuit board 1400. The touch driver 1500 may be electrically connected, through the circuit board 1400, to the touch electrodes TCE (see FIG. 4) of the touch unit 200 of the display module DM. The touch driver 1500 may be electrically connected to the first and second signal lines SL1 and SL2 (see FIG. 4) of the touch unit 200 through the circuit board 1400.

However, in addition thereto, a power supply unit may further be disposed on the circuit board 1400. The power supply unit may supply a driving voltage for driving the pixels and the display driver 1200 of the display panel 100.

The display module DM may include the display panel 100, the touch unit 200, and the planarization layer 300.

The display panel 100 may include a display element. For example, the display panel 100 may include, as a light-emitting device, an organic light-emitting diode (OLED) including an organic emission layer, an inorganic light-emitting diode including an inorganic emission layer, or a quantum-dot light-emitting diode including a quantum-dot emission layer.

The touch unit 200 may be disposed on the display panel 100. The touch unit 200 may sense coordinate information based on an external input.

The planarization layer 300 may be disposed on the touch unit 200. The planarization layer 300 may be disposed on the display panel 100 and the touch unit 200 and may planarize an upper surface of the display module DM.

According to an embodiment, the planarization layer 300 may be disposed in the first non-bending area NBA1 and may extend to entirely overlap the bending area BA. For example, the planarization layer 300 may be disposed in the first non-bending area NBA1 and may extend from the first non-bending area NBA1 to the second non-bending area NBA2. The planarization layer 300 may be disposed in the display area DA in which the light-emitting device is disposed and the first peripheral area PA1 and may extend from the display area DA to the second non-bending area NBA2. For example, a portion of the planarization layer 300 may be disposed in the display area DA and the first peripheral area PA1, another portion of the planarization layer 300 may be disposed in the bending area BA, and another portion of the planarization layer 300 may be disposed in the second non-bending area NBA2.

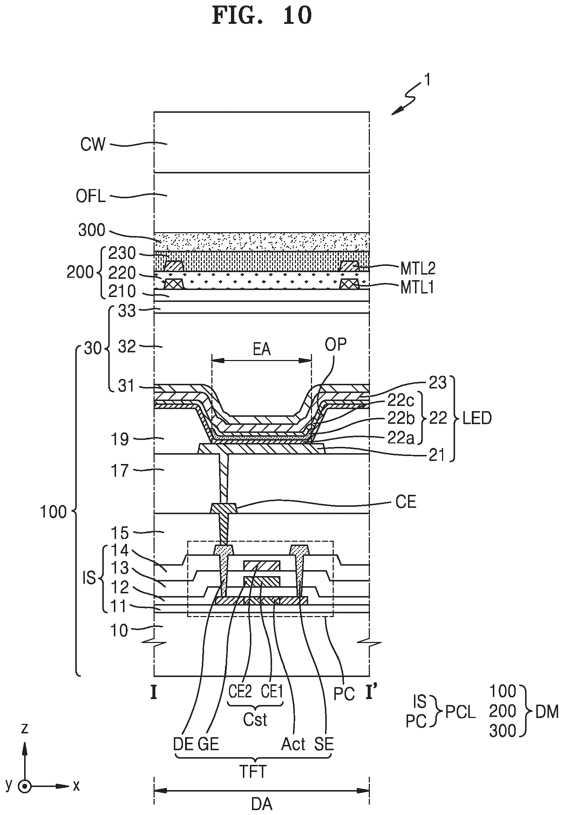

According to an embodiment, the planarization layer 300 may be disposed in the first non-bending area NBA1 and may extend from the first non-bending area NBA1 to an area in which the stiffener 1100 is disposed. The planarization layer 300 may be disposed in the display area DA and may extend from the display area DA to the area in which the stiffener 1100 is disposed. For example, the planarization layer 300 may extend from the first non-bending area NBA1 to the area in which the stiffener 1100 is disposed in order to overlap the stiffener 1100. The planarization layer 300 may overlap a portion of the stiffener 1100. In this specification, that "A and B overlap each other" may be defined to denote that A and B overlap each other in a thickness direction of the display panel 100, for example, in a direction perpendicular to an upper surface of the substrate 10 (see FIG. 10) of the display panel 100 (or a z-axis direction).

According to an embodiment, the planarization layer 300 may be disposed in the first non-bending area NBA1 and may extend from the first non-bending area NBA1 to an area in which the adhesive 1100P is disposed. The planarization layer 300 may be disposed in the display area DA and may extend from the display area DA to the area in which the adhesive 1100P is disposed. For example, the planarization layer 300 may extend from the first non-bending area NBA1 to the area in which the adhesive 1100P is disposed and may contact at least one surface of the adhesive 1100P or overlap the adhesive 1100P. The planarization layer 300 may overlap a portion of the adhesive 1100P. The planarization layer 300 may be disposed in the first non-bending area NBA1 and may extend from the first non-bending area NBA1 to a portion of the second non-bending area NBA2 and may thus be disposed in the bending area BA.

According to an embodiment, the planarization layer 300 may cover the display panel 100 and the touch unit 200 therebelow in some portions of the bending area BA and the second non-bending area NBA2, and thus, the planarization layer 300 may planarize upper surfaces of the display panel 100 and the touch unit 200 disposed in the bending area BA and the second non-bending area NBA2 and at the same time may protect the components included in the display panel 100 and the components included in the touch unit 200 from external materials. For example, as described above with reference to FIG. 4, one or more of the first signal lines SL1 and one or more of the second signal lines SL2 of the touch unit 200 may be disposed in the bending area BA and the second non-bending area NBA2, and the planarization layer 300 may overlap the one or more of the first signal lines SL1 and the one or more of the second signal lines SL2 disposed in the bending area BA and the second non-bending area NBA2. For example, the planarization layer 300 may prevent or reduce damage to the first and second signal lines SL1 and SL2 disposed in the bending area BA and the second non-bending area NBA2, the damage being caused by the penetration of external materials.

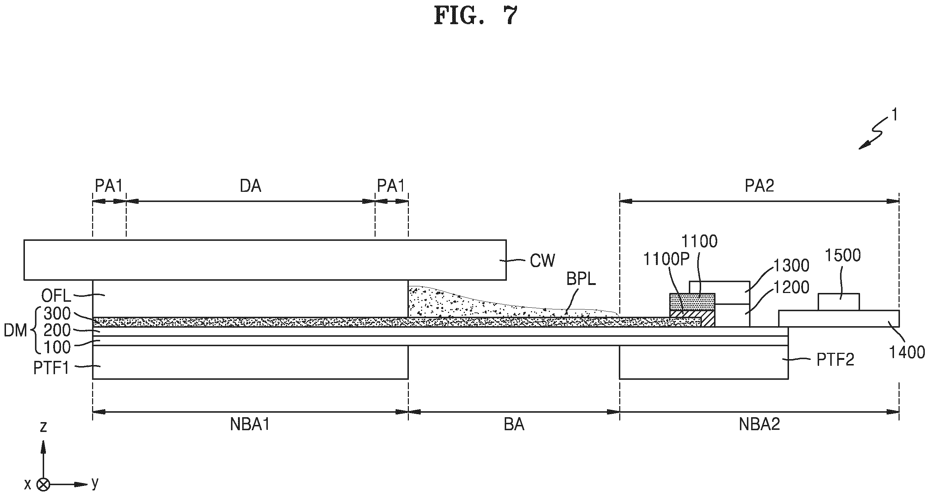

According to an embodiment, the planarization layer 300 may be disposed in the bending area BA and may prevent damage to the display module DM due to the penetration of external materials as well as may reduce the size of the stress formed in the bending area BA when the display module DM is bent, and thus, the occurrence of cracks and the damage to the display module DM may be minimized or prevented. Because the planarization layer 300 may reduce the size of the stress in the bending area BA, the display apparatus 1 might not provide an additional bending protection layer on the display module DM. However, embodiments of the disclosure are not necessarily limited thereto, and according to an embodiment illustrated in FIG. 7, a bending protection layer BPL may further be included.

The planarization layer 300 may include an organic material. The planarization layer 300 may include, for example, a polymer-based material. The polymer-based material may include, for example, acryl-based resins, epoxy-based resins, polyimide, polyethylene, etc. The planarization layer 300 may be formed, for example, by an inkjet printing process.

As illustrated in FIG. 5B, the bending area BA of the display module DM may be bent such that the second peripheral area PA2 may overlap the display area DA and/or the first peripheral area PA1 on a rear surface of the display module DM. For example, the bending area BA of the display module DM may be bent such that the second non-bending area NBA2 may overlap the first non-bending area NBA1 on the rear surface of the display module DM. By doing so, an area of the peripheral area PA of the display apparatus 1, for example, a dead space, may be reduced.

The first protection film PTF1 and the second protection film PTF2 may be patterned and bonded to a lower surface of the display panel 100. The first protection film PTF1 and the second protection film PTF2 may be patterned and bonded to a lower surface of the substrate 10 (see FIG. 10) of the display panel 100. The first protection film PTF1 may be disposed in the first non-bending area NBA1 and the second protection film PTF2 may be disposed in the second non-bending area NBA2. The first protection film PTF1 and the second protection film PTF2 may be spaced apart from each other with the bending area BA therebetween.

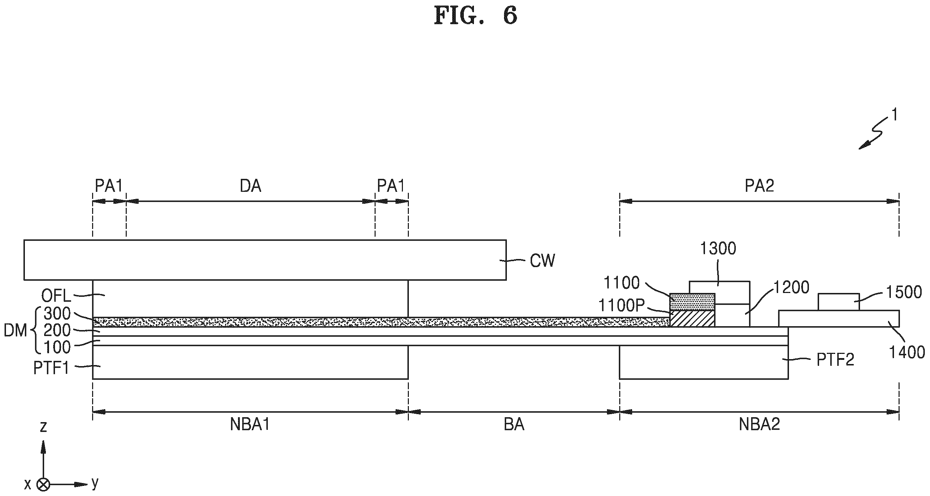

FIG. 6 is a schematic cross-sectional view of a portion of the display apparatus 1 according to an embodiment. FIG. 7 is a schematic cross-sectional view of a portion of the display apparatus 1 according to an embodiment.

FIGS. 6 and 7 are modified embodiments of the embodiment described with reference to FIGS. 5A and 5B. To the extent that an element is not described in detail with respect to this figure, it may be understood that the element is at least similar to a corresponding element that has been described elsewhere within the present disclosure.

Referring to FIG. 6, the planarization layer 300 may be in contact with a side surface of the adhesive 1100P. For example, an edge of the planarization layer 300 may be in contact with the side surface of the adhesive 1100P. For example, the planarization layer 300 may be in contact with the side surface of the adhesive 1100P while not overlapping the stiffener 1100. In the embodiment, the planarization layer 300 may also extend from the first non-bending area NBA1 to the second non-bending area NBA2 to entirely cover the bending area BA, and thus, may protect the display module DM from the penetration of external materials and may prevent or minimize the occurrence of cracks due to stress.

Referring to FIG. 7, the display apparatus 1 may further include a bending protection layer BPL disposed on the display module DM in the bending area BA. The bending protection layer BPL may be disposed on the entire surface of the display module DM. For example, the bending protection layer BPL may be disposed above the display panel 100, the touch unit 200, and the planarization layer 300. The bending protection layer BPL may be disposed on the planarization layer 300. According to an embodiment, the bending protection layer BPL may be bonded to the display module DM through an adhesive. The bending protection layer BPL may include polymer resins, such as polyethyleneterephthalate (PET), polyimide (PI), etc.

The bending protection layer BPL may protect the bent display module DM from external shock and may support the display module DM to relatively maintain its shape when the display module DM is bent. Also, by providing the bending protection layer BPL, maximum internal stress formed in the bending area BA of the display module DM may be reduced. Here, the maximum internal stress may occur in a position farthest from a neutral plane in which internal stress is 0 (null).

In the display apparatus 1, according to an embodiment shown in FIG. 6, the bending protection layer BPL may further be included in the bending area BA, similarly to FIG. 7.

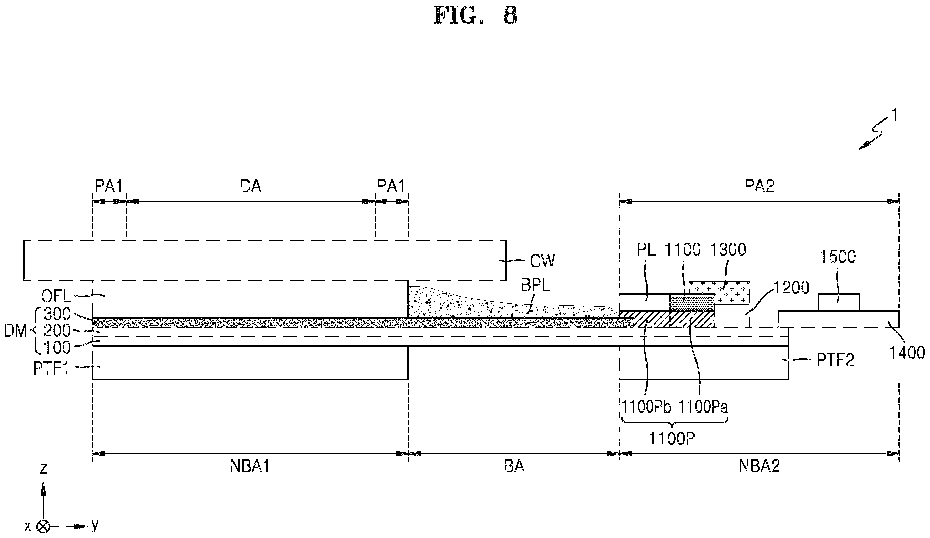

FIG. 8 is a schematic cross-sectional view of a portion of the display apparatus 1, according to an embodiment. The embodiment of FIG. 8 is a modified embodiment of the embodiment described with reference to FIG. 7. To the extent that an element is not described in detail with respect to this figure, it may be understood that the element is at least similar to a corresponding element that has been described elsewhere within the present disclosure.

Referring to FIG. 8, the display apparatus 1 may include the bending protection layer BPL disposed in the bending area BA.

According to an embodiment, an area of the adhesive 1100P may be greater than an area of the stiffener 1100 in a plan view in a first direction (for example, an x-axis direction) and a second direction (for example, a y-axis direction). For example, the adhesive 1100P may include a first portion 1100Pa overlapping the stiffener 1100 and a second portion 1100Pb that does not overlap the stiffener 1100. The second portion 1100Pb of the adhesive 1100P, according to an embodiment, may extend from the first portion 1 100Pa to be adjacent to or to overlap the bending area BA. The second portion 1100Pb of the adhesive 1100P, according to an embodiment, may extend from the first portion 1 100Pa to be in contact with the bending protection layer BPL. The adhesive 1100P may be in contact with the bending protection layer BPL. A side surface of the adhesive 1100P may be in contact with the bending protection layer BPL. The second portion 1100Pb of the adhesive 1100P may be in contact with the bending protection layer BPL.

In the embodiment, the adhesive 1100P and the bending protection layer BPL may be in contact with each other and may cover portions of the bending area BA and the second non-bending area NBA2 of the display module DM, and thus, a gap might not be generated between the bending protection layer BPL and the adhesive 1100P. Thus, the damage to the display module DM due to the penetration of external materials may be prevented or minimized.

According to an embodiment, the protection layer PL may further be disposed on the second portion 1100Pb of the adhesive 1100P. The protection layer PL may include, for example, a film layer.

According to an embodiment, the planarization layer 300 may be disposed in the first non-bending area NBA1 and may extend from the first non-bending area NBA1 to an area in which the adhesive 1100P is disposed. The planarization layer 300 may be disposed in the display area DA and may extend from the display area DA to the area in which the adhesive 1100P is disposed. According to an embodiment, it is illustrated that the planarization layer 300 may be disposed in the first non-bending area NBA1 and may extend from the first non-bending area NBA1 to the second portion 1100Pb of the adhesive 1100P. However, the planarization layer 300 is not necessarily limited thereto. According to an embodiment, the planarization layer 300 may be disposed in the first non-bending area NBA1 and may extend from the first non-bending area NBA1 to the first portion 1100Pa of the adhesive 1100P. According to an embodiment, the planarization layer 300 may extend from the first non-bending area NBA1 to the area in which the adhesive 1100P is disposed, so as to be in contact with at least one surface of the second portion 1 100Pb of the adhesive 1100P or to overlap the second portion 1 100Pb of the adhesive 1100P.

According to an embodiment, the planarization layer 300 may extend to overlap the first portion 1100Pa of the adhesive 1100P. For example, according to an embodiment, the planarization layer 300 may extend to partially overlap the stiffener 1100.

According to an embodiment, the planarization layer 300 may be disposed in the first non-bending area NBA1 and may not extend from the first non-bending area NBA1 to the bending area BA. For example, the planarization layer 300 may be disposed only in the first non-bending area NBA1 and may not overlap the bending area BA and the second non-bending area NBA2.

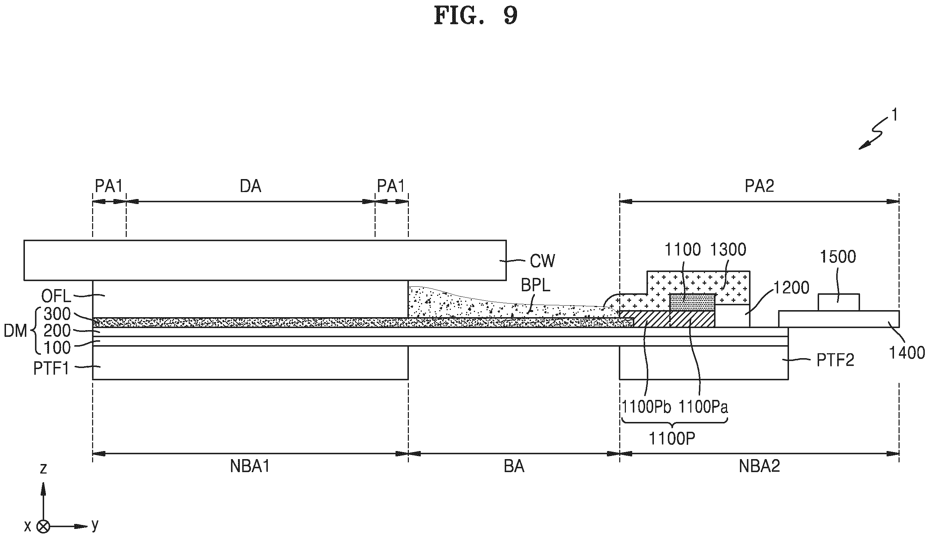

FIG. 9 is a schematic cross-sectional view of a portion of a display apparatus according to an embodiment. FIG. 9 is a modified embodiment of the embodiment of FIG. 8, and thus, to the extent that an element is not described in detail with respect to this figure, it may be understood that the element is at least similar to a corresponding element that has been described elsewhere within the present disclosure.

Referring to FIG. 9, the cover 1300 may overlap the display driver 1200, the stiffener 1100, and the adhesive 1100P. According to an embodiment, the cover 1300 may be disposed on the display driver 1200 and the stiffener 1100 and may extend to overlap the second portion 1100Pb of the adhesive 1 100P. The cover 1300 may overlap the first portion 1100Pa and the second portion 1 100Pb of the adhesive 1100P. The cover 1300 may be in contact with the second portion 1 100Pb of the adhesive 1100P. According to an embodiment, the cover 1300 may be in contact with the bending protection layer BPL. The cover 1300 may overlap the second portion 1100Pb of the adhesive 1100P extending from the first portion 1100Pa of the adhesive 1100P to be in contact with bending protection layer BPL, and thus, the adhesive 1100P and the cover 1300 may doubly prevent or minimize the damage to the display module DM due to the penetration of external materials.

According to an embodiment, the planarization layer 300 may be disposed in the first non-bending area NBA1 and may extend from the first non-bending area NBA1 to an area in which the adhesive 1100P is disposed. According to an embodiment, the planarization layer 300 may be disposed in the first non-bending area NBA1 and may not extend from the first non-bending area NBA1 to the bending area BA. For example, the planarization layer 300 may be disposed only in the first non-bending area NBA1 and may not overlap the bending area BA and the second non-bending area NBA2.

FIG. 10 is a schematic cross-sectional view of a portion of the display apparatus 1 in the display area DA, according to an embodiment. FIG. 10 illustrates a portion of the display apparatus 1 in a cross-sectional view taken along line I-I' of FIG. 3.

Referring to FIG. 10, the display apparatus 1 may include the display module DM, the optical functional layer OFL and the cover window CW on the display module DM.

The display module DM may include the display panel 100, the touch unit 200 on the display panel 100, and the planarization layer 300 on the touch unit 200.

The display panel 100 may include the substrate 10, the pixel circuit layer PCL on the substrate 10, the light-emitting device LED on the pixel circuit layer PCL, and an encapsulation structure 30 on the light-emitting device LED.

The substrate 10 may include glass or polymer resins. The polymer resins may include polyether sulfone, polyacrylate, polyether imide, polyethylene naphthalate, polyethylene terephthalate, polyphenylene sulfide, polyarylate, polyimide, polycarbonate, cellulose acetate propionate, or the like. The substrate 10 including the polymer resins may be flexible, rollable, or bendable. The substrate 10 may have a layered structure including a layer including the polymer resins described above and an inorganic layer.

The pixel circuit layer PCL may include: the pixel circuit PC including the thin-film transistor TFT and the storage capacitor Cst; and an insulating structure IS including a plurality of insulating layers. The insulating structure IS may include a buffer layer 11, a first gate insulating layer 12, a second gate insulating layer 13, and an interlayer insulating layer 14.

The buffer layer 11 may be located on the substrate 10, may reduce or prevent penetration of foreign materials, moisture, or external air from below the substrate 10, and may planarize a semiconductor layer Act. The buffer layer 11 may include an inorganic material, such as oxide or nitride, an organic material, or an organic and inorganic compound, and may have a single-layered structure or a multi-layered structure including the inorganic material and the organic material. A barrier layer preventing the penetration of foreign substances may further be between the substrate 10 and the buffer layer 11.

The pixel circuit PC including the thin-film transistor TFT and the storage capacitor Cst may be disposed on the buffer layer 11. The thin-film transistor TFT may include a semiconductor layer Act, a gate electrode GE, a drain electrode DE, and a source electrode SE.

The semiconductor layer Act may be disposed on the buffer layer 11 and may include polysilicon. According to an embodiment, the semiconductor layer Act may include amorphous silicon. According to an embodiment, the semiconductor layer Act may include oxide of In, Ga, Sn, Zr, V, Hf, Cd, Ge, Cr, Ti, and/or Zn. The semiconductor layer Act may include a channel area, and a source area and a drain area doped with impurities. The source area and the drain area may be disposed at both sides of the channel area.

The first gate insulating layer 12 may cover the semiconductor layer Act. The first gate insulating layer 12 may include an inorganic insulating material, such as SiO₂, SiNₓ, SiON, Al₂O₃, TiO₂, Ta₂O₅, HfO₂, or ZnOₓ(which may be ZnO and/or ZnO₂). The first gate insulating layer 12 may include a single layer or multiple layers including the inorganic insulating materials described above.

The gate electrode GE may be disposed above the first gate insulating layer 12 to overlap the semiconductor layer Act. The gate electrode GE may include Mo, Al, Cu, Ti, etc., and may include a single layer or layers. For example, the gate electrode GE may include a single layer of Mo.

The second gate insulating layer 13 may cover the gate electrode GE. The second gate insulating layer 13 may include an inorganic insulating material, such as SiO₂, SiNₓ, SiON, Al₂O₃, TiO₂, Ta₂O₅, HfO₂, or ZnOₓ(which may be ZnO and/or ZnO₂). The second gate insulating layer 13 may include a single layer or multiple layers including the inorganic insulating materials described above.

A second capacitor electrode CE2 of the storage capacitor Cst may be disposed on the second gate insulating layer 13. The second capacitor electrode CE2 may overlap the gate electrode GE. The gate electrode GE and the second capacitor electrode CE2 may overlap each other with the second gate insulating layer 13 therebetween and may form the storage capacitor Cst. For example, the gate electrode GE may function as a first capacitor electrode CE1 of the storage capacitor Cst.

The second capacitor electrode CE2 may include Al, Pt, Pd, Ag, Mg, Au, Ni, Nd, Ir, Cr, Ca, Mo, Ti, W, and/or Cu and may include a single layer or layers including the materials described above.

The interlayer insulating layer 14 may cover the second capacitor electrode CE2. The interlayer insulating layer 14 may include SiO₂, SiNₓ, SiON, Al₂O₃, TiO₂, Ta₂O₅, HfO₂, or ZnOₓ(which may be ZnO and/or ZnO₂). The interlayer insulating layer 14 may include a single layer or layers including the inorganic insulating material described above.

The source electrode SE and the drain electrode DE may be disposed on the interlayer insulating layer 14. The source electrode SE and the drain electrode DE may include a conductive material including Mo, Al, Cu, Ti, etc., and may include multiple layers or a single layer including the materials described above. For example, the source electrode SE and the drain electrode DE may have a multi-layered structure including Ti/Al/Ti. According to some embodiments, the source electrode SE or the drain electrode DE may be omitted. For example, adjacent thin-film transistors TFT may share the source area or the drain area of the semiconductor layer Act, and the source area or the drain area may function as the source electrode SE or the drain electrode DE.

A first planarization insulating layer 15 may cover the source electrode SE and the drain electrode DE. A connection electrode CE may be disposed on the first planarization insulating layer 15. A second planarization insulating layer 17 may further be disposed on the first planarization insulating layer 15 to cover the connection electrode CE. The second planarization insulating layer 17 may provide a flat base surface to a pixel electrode 21 disposed thereabove. The pixel electrode 21 and the thin-film transistor TFT may be electrically connected to each other by the connection electrode CE. In this specification, two planarization insulating layers are described. However, embodiments of the disclosure are not necessarily limited thereto, and the number of planarization insulating layers may be variously modified.

The first and second planarization insulating layers 15 and 17 may include an organic material or an inorganic material and may have a single-layered structure or a multi-layered structure. The first and second planarization insulating layers 15 and 17 may include a general-purpose polymer such as benzocyclobutene (BCB), PI, hexamethyldisiloxane (HMDSO), polymethylmethacrylate (PMMA), or polystyrene (PS), a polymer derivate having a phenol-based group, an acryl-based polymer, an imide-based polymer, an aryl ether-based polymer, an amide-based polymer, a fluorine-based polymer, a p-xylene-based polymer, or a vinyl alcohol-based polymer. The first and second planarization insulating layers 15 and 17 may include an inorganic insulating material, such as SiO₂, SiNₓ, SiON, Al₂O₃, TiO₂, Ta₂O₅, HfO₂, or ZnOₓ(which may be ZnO and/or ZnO₂). When forming the first and second planarization insulating layers 15 and 17, chemical mechanical polishing may be performed on an upper surface of a layer that is formed, in order to provide a flat upper surface.

A light-emitting device LED may be disposed on the second planarization insulating layer 17. The light-emitting device LED may include the pixel electrode 21, an intermediate layer 22, and an opposite electrode 23.

The pixel electrode 21 may be disposed on the second planarization insulating layer 17. The pixel electrode 21 may include conductive oxide, such as indium tin oxide (ITO), indium zinc oxide (IZO), zinc oxide (ZnO), indium oxide (In₂O₃), indium gallium oxide (IGO), or aluminum zinc oxide (AZO). The pixel electrode 21 may include a reflective layer including Ag, Mg, Al, Pt, Pd, Au, Ni, Nd, Ir, Cr, or a compound thereof. For example, the pixel electrode 21 may have a structure in which the pixel electrode 21 includes layers including ITO, IZO, ZnO or In₂O₃ above/below the reflective layer described above. In this case, the pixel electrode 21 may have a structure in which ITO/Ag/ITO layers are stacked.

A pixel-defining layer 19 may cover an edge of the pixel electrode 21 on the second planarization insulating layer 17 and may include a pixel opening OP exposing a central portion of the pixel electrode 21. An emission area EA of the light-emitting device LED, for example, a size and a shape of a pixel, may be defined by the pixel opening OP.

The pixel-defining layer 19 may increase a distance between the edge of the pixel electrode 21 and an opposite electrode 23 above the pixel electrode 21 so as to prevent arcs, etc. from occurring at the edge of the pixel electrode 21.

The pixel-defining layer 19 may be formed by using a spin coating method, etc., by using an organic insulating material, such as PI, polyamide, acryl resins, BCB, HMDSO, phenol resins, etc.

According to an embodiment, the pixel-defining layer 19 may further include a light-blocking material. The light-blocking material may include a resin or paste including carbon black, a carbon nano-tube, or a black dye, a metal particle, such as Ni, Al, Mo, and an alloy thereof, a metal oxide particle (for example, chromium oxide), a metal nitride particle (for example, chromium nitride), or the like. When the pixel-defining layer 19 includes the light-blocking material, reflection of external light due to metal structures disposed below the pixel-defining layer 19 may be reduced.

The intermediate layer 22 may be disposed between the pixel electrode 21 and the opposite electrode 23. The intermediate layer 22 may include a first functional layer 22a, an emission layer 22b, and a second functional layer 22c.

The emission layer 22b formed to correspond to the pixel electrode 21 may be disposed in the pixel opening OP of the pixel-defining layer 19. The emission layer 22b may include a high-molecular weight material or a low-molecular weight material and may emit red, green, blue, or white light.

The first functional layer 22a and the second functional layer 22c may be disposed below and/or above the emission layer 22b. According to an embodiment, unlike the emission layer 22b patterned and arranged for each pixel, the first functional layer 22a and the second functional layer 22c may be integrally provided on the entire surface of the display area DA.

The first functional layer 22a may include a single layer or multiple layers. For example, when the first functional layer 22a includes a high molecular-weight material, the first functional layer 22a may include a hole transport layer (HTL) having a single-layered structure and may include poly-(3,4-ethylene-dioxy thiophene) (PEDOT) or polyaniline (PANI). When the first functional layer 22a includes a low molecular-weight material, the first functional layer 22a may include a hole injection layer and a hole transport layer.

The second functional layer 22c may be selectively disposed. For example, when the first functional layer 22a and the emission layer 22b include a high molecular-weight material, it may be desirable to form the second functional layer 22c. The second functional layer 22c may include a single layer or multiple layers. The second functional layer 22c may include an electron transport layer and/or an electron injection layer. According to some embodiments, at least one of the hole injection layer, the hole transport layer, the electron transport layer, and the electron injection layer may be omitted.

The opposite electrode 23 may include a conductive material having a low work function. For example, the opposite electrode 23 may include a (semi-) transparent layer including Ag, Mg, Al, Ni, Cr, Li, Ca, or an alloy thereof. Alternatively, the opposite electrode 23 may further include a layer, such as ITO, IZO, ZnOₓ(which may be ZnO and/or ZnO₂), or In₂O₃, on the (semi-) transparent layer including the materials described above. According to an embodiment, the opposite electrode 23 may include Ag and Mg.

According to an embodiment, a capping layer may be disposed on the light-emitting device LED. The capping layer may improve the emission efficiency of the light-emitting device LED based on a constructive interference principle. The capping layer may include an organic capping layer including an organic material, an inorganic capping layer including an inorganic material, or a complex capping layer including an organic material and an inorganic material.

The encapsulation structure 30 may be disposed on the light-emitting device LED. The encapsulation structure 30 may encapsulate the light-emitting device LED. According to an embodiment, the encapsulation structure 30 may include at least one inorganic encapsulation layer and at least one organic encapsulation layer. For example, the encapsulation structure 30 may include a first inorganic encapsulation layer 31, a second inorganic encapsulation layer 33, and an organic encapsulation layer 32 interposed therebetween.

Each of the first and second inorganic encapsulation layers 31 and 33 may include at least one inorganic insulating material. The inorganic insulating material may include Al₂O₃, TiO₂, Ta₂O₅, HfO₂, ZnO, SiO₂, SiNₓ, or/and SiON. The first and second inorganic encapsulation layers 31 and 33 may be formed by chemical vapor deposition.

The organic encapsulation layer 32 may include polyethyleneterephthalate, polyethylenenaphthalate, polycarbonate, polyimide, polyethylenesulfonate, polyoxymethylene, polyarylate, HMDSO, acryl-based resins, or a combination thereof.

The encapsulation structure 30 may include the organic encapsulation layer 32 as described above and may provide a planarized base surface. Thus, even when the components of the touch unit 200 are formed by sequential processes, defect rates may be reduced.

The touch unit 200 may be disposed on the display panel 100. The touch unit 200 may have a multi-layered structure. The touch unit 200 may include a driving electrode TE (see FIG. 4), the first signal line SL1 (see FIG. 4) connected to the driving electrode TE, the sensing electrode RE (see FIG. 4), the second signal line SL2 (see FIG. 4) connected to the sensing electrode RE, and at least one insulating layer. A touch sensor included in the touch unit 200 may sense an external input for example by a capacitance method.

The touch unit 200 may include a first touch insulating layer 210, a first touch conductive layer MTL1, a second touch insulating layer 220, a second touch conductive layer MTL2, and a third touch insulating layer 230.

The first touch insulating layer 210 may be disposed directly on the encapsulation structure 30. The first touch insulating layer 210 may include an inorganic material or an organic material and may include a single layer or multiple layers.

The first touch insulating layer 210 may prevent damage to the encapsulation structure 30 and may block an interference signal which may be generated while the touch unit 200 is being driven.

For example, each of the first touch conductive layer MTL1 and the second touch conductive layer MTL2 may have a single-layered structure or a multi-layered structure in which layers are stacked. The conductive layer having a single-layered structure may include a metal layer or a transparent conductive layer. The metal layer may include Mo, Ag, Ti, Cu, Al, and an alloy thereof. The transparent conductive layer may include transparent conductive oxide, such as indium tin oxide (ITO), indium zinc oxide (IZO), zinc oxide (ZnO), indium tin zinc oxide (ITZO), etc. In addition, the transparent conductive layer may include a conductive polymer, such as PEDOT, a metal nano-wire, graphene, etc.

The conductive layer having a multi-layered structure may include a plurality of metal layers. The plurality of metal layers may have, for example, a tri-layered structure of Ti/Al/Ti. The conductive layer having a multi-layered structure may include at least one metal layer and at least one transparent conductive layer.

According to an embodiment, each of the first touch conductive layer MTL1 and the second touch conductive layer MTL2 may include a plurality of patterns. It may be understood that the first touch conductive layer MTL1 may include first conductive patterns and the second touch conductive layer MTL2 may include second conductive patterns. The first conductive patterns and the second conductive patterns may form a touch sensor.

The first touch conductive layer MTL1 and the second touch conductive layer MTL2 may be electrically connected to each other through a contact hole. According to an embodiment, the first touch conductive layer MTL1 and the second touch conductive layer MTL2 may have a mesh structure transmitting light emitted from the light-emitting device LED. Here, the first touch conductive layer MTL1 and the second touch conductive layer MTL2 might not overlap the emission area EA.

The second touch insulating layer 220 may include an organic material. The organic material may include acryl-based resins, methacryl-based resins, polyisoprene, vinyl-based resins, epoxy-based resins, urethane-based resins, cellulose-based resins, and/or pherylene-based resins. The second touch insulating layer 220 may further include an inorganic material. The inorganic material may include SiNₓ, AlN, ZrN, TiN, HfN, TaN, SiOₓ, Al₂O₃, TiO₂, SnO₂, CeO₂, and/or SiON.

The third touch insulating layer 230 may be disposed on the second touch conductive layer MTL2. The third touch insulating layer 230 may have a single-layered or multi-layered structure. The third touch insulating layer 230 may include an organic material, an inorganic material, or a compound material.

The planarization layer 300 may be disposed on the touch unit 200. The planarization layer 300 may be disposed in the display area DA and may planarize an upper surface of the display module DM. The planarization layer 300 may be disposed on the third touch insulating layer 230. The planarization layer 300 may be formed by a separate process from the first to third touch insulating layers 210, 220, and 230 of the touch unit 200. According to an embodiment, a thickness of the planarization layer 300 may be greater than a thickness of each of the first to third touch insulating layers 210 to 230.

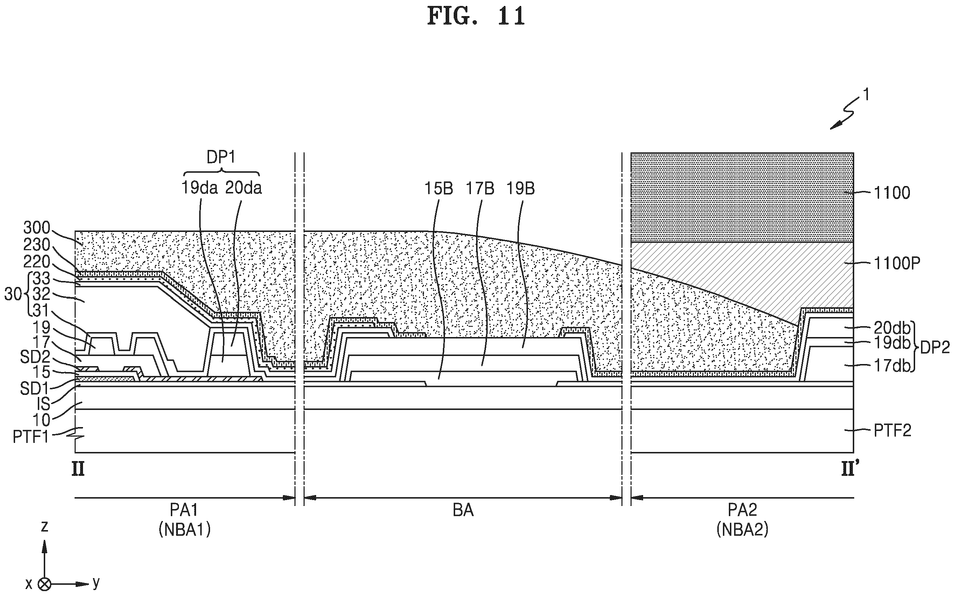

FIG. 11 is a schematic cross-sectional view of a portion of the display apparatus 1 in the peripheral area PA, according to an embodiment. FIG. 11 illustrates a portion of the display apparatus 1 in a cross-sectional view taken along line II-II' of FIG. 4.

Referring to FIGS. 3, 4, and 11 together, the first dam portion DP1 may be disposed in the first peripheral area PA1 and a portion of the second dam portion DP2 may be disposed in the second peripheral area PA2.

In the first peripheral area PA1, the display apparatus 1 may include the first protection film PTF1, the substrate 10 on the first protection film PTF1, the insulating structure IS on the substrate 10, a first conductive layer SD1 on the insulating structure IS, the first planarization insulating layer 15 on the first conductive layer SD1, a second conductive layer SD2 on the first planarization insulating layer 15, the second planarization insulating layer 17 on the second conductive layer SD2, the pixel-defining layer 19, and the encapsulation structure 30 on the pixel-defining layer 19. The first conductive layer SD1 may be formed by the same process as the source electrode SE or the drain electrode DE described with reference to FIG. 10. The second conductive layer D2 may be formed by the same process as the connection electrode CE described with reference to FIG. 10.

The first dam portion DP1 may include a first layer 19da and a second layer 20da that are sequentially stacked. The second layer 20da of the first dam portion DP1 may be disposed on the first layer 19da of the first dam portion DP1. The first layer 19da of the first dam portion DP1 may be formed by the same process as the pixel-defining layer 19 and may include the same material as that of the pixel-defining layer 19. The second layer 20da of the first dam portion DP1 may be formed by the same process as a spacer disposed above the pixel-defining layer 19 in the display area DA and may include the same material as that of the spacer.

The organic encapsulation layer 32 may be disposed at an inner side of the first dam portion DP1. The first dam portion DP1 may function as a dam to prevent flowing of an organic material in a direction toward an edge of the substrate 10 when the organic encapsulation layer 32 included in the encapsulation structure 30 is formed by an inkjet process, and thus, an edge tail may be prevented from being formed at the edge of the substrate 10 due to the organic encapsulation layer 32.

The first and second inorganic encapsulation layers 31 and 33 may be in contact with each other in an area overlapping the first dam portion DP1.

In the bending area BA, the display apparatus 1 may include the substrate 10, the insulating structure IS on the substrate 10, and a first insulating layer 15B, a second insulating layer 17B, and a third insulating layer 19B on the insulating structure IS. The first insulating layer 15B may be formed by the same process as the first planarization insulating layer 15 and may include the same material as that of the first planarization insulating layer 15. The second insulating layer 17B may be formed by the same process as the second planarization insulating layer 17 and may include the same material as that of the second planarization insulating layer 17. The third insulating layer 19B may be formed by the same process as the spacer disposed above the pixel-defining layer 19 in the display area DA and may include the same material as that of the spacer.

It is illustrated that the second touch insulating layer 220 and the third touch insulating layer 230 of the touch unit 200 (see FIG. 10) may be disposed in the first peripheral area PA1 and may extend to a portion of the bending area BA and other portions of the touch unit 200 are disposed in the second peripheral area PA2. However, arrangement of the touch insulating layers 220 and 230 of the touch unit 200 may be variously changed.

According to an embodiment, the planarization layer 300 may be disposed on the third touch insulating layer 230 of the touch unit 200 (see FIG. 10). The planarization layer 300 may be disposed in the first peripheral area PA1 and may extend from the first peripheral area PA1 to the second peripheral area PA2.

The second dam portion DP2 may be disposed in at least the second peripheral area PA2 (or the second non-bending area NBA2). The second dam portion DP2 may include a first layer 17db, a second layer 19db, and a third layer 20db that are sequentially stacked. The second layer 19db of the second dam portion DP2 may be disposed on the first layer 17db of the second dam portion DP2. The third layer 20db of the second dam portion DP2 may be disposed on the second layer 19db of the second dam portion DP2. The first layer 17db of the second dam portion DP2 may be formed by the same process as the second planarization insulating layer 17 and may include the same material as that of the second planarization insulating layer 17. The second layer 19db of the second dam portion DP2 may be formed by the same process as the pixel-defining layer 19 and may include the same material as that of the pixel-defining layer 19. The third layer 20db of the second dam portion DP2 may be formed by the same process as the spacer disposed above the pixel-defining layer 19 and may include the same material as that of the spacer.

The planarization layer 300 may be disposed at an inner side of the second dam portion DP2. The second dam portion DP2 may function as a dam to block an organic material from flowing to the outside of the second dam portion DP2 when the planarization layer 300 is formed by an inkjet process. Accordingly, the planarization layer 300 may extend from the first non-bending area NBA1 including the display area DA (see FIG. 10) and the first peripheral area PA1 to the second non-bending area NBA2 in which the second dam portion DP2 is disposed. Accordingly, the planarization layer 300 may cover the substrate 10 in the first non-bending area NBA1, the bending area BA, and the second non-bending area NBA2.

According to an embodiment, a portion of the second dam portion DP2 may overlap the stiffener 1100. According to an embodiment, a portion of the second dam portion DP2 may overlap the adhesive 1100P.

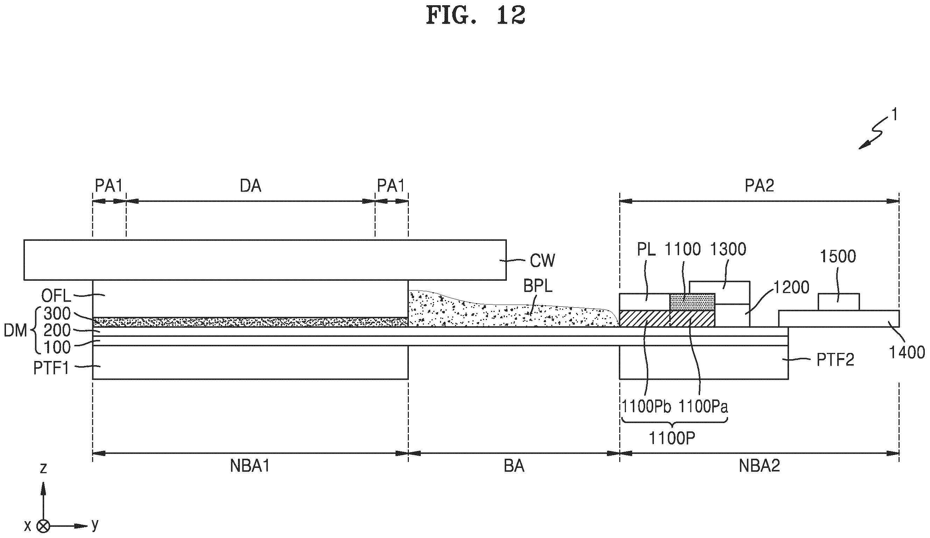

FIG. 12 is a schematic cross-sectional view of a portion of the display apparatus 1 according to an embodiment. FIG. 12 is a modified embodiment of FIG. 8, and thus, to the extent that an element is not described in detail with respect to this figure, it may be understood that the element is at least similar to a corresponding element that has been described elsewhere within the present disclosure.

Referring to FIG. 12, the planarization layer 300 may be disposed in the first non-bending area NBA1 and might not extend from the first non-bending area NBA1 to the bending area BA. For example, the planarization layer 300 may be disposed only in the first non-bending area NBA1 and might not overlap the bending area BA and the second non-bending area NBA2. However, also, in this case, the adhesive 1100P and the bending protection layer BPL may be in contact with each other and may cover portions of the bending area BA and the second non-bending area NBA2 of the display module DM, and thus, a gap might not be generated between the bending protection layer BPL and the adhesive 1100P. Thus, damage to the display module DM due to the penetration of external materials may be prevented or minimized. The structure described with reference to FIG. 9, in which the cover 1300 may overlap the second portion 1100Pb of the adhesive 1100P may be likewise implemented in the embodiment described with reference to FIG. 12, in which the planarization layer 300 might not extend from the first non-bending area NBA1 to the bending area BA.

As discussed, embodiments may provide a display apparatus, comprising: a display module including a bending area, a first non-bending area, and a second non-bending area, the first non-bending area and the second non-bending area being spaced apart from each other with the bending area interposed therebetween; a display driver disposed in the second non-bending area; a stiffener disposed in the second non-bending area and adjacent to the display driver; and an adhesive disposed in the second non-bending area and on a lower surface of the stiffener, wherein the display module includes a display panel including a display element, a touch unit disposed on the display panel and including a touch electrode and a signal line, and a planarization layer disposed on the touch unit, wherein the planarization layer is disposed in the first non-bending area and extends from the first non-bending area to the second non-bending area.

Embodiments may provide a display apparatus, comprising: a display module including a bending area, a first non-bending area, and a second non-bending area, the first non-bending area and the second non-bending being spaced apart from each other with the bending area interposed therebetween; a display driver disposed in the second non-bending area; and a stiffener disposed in the second non-bending area and adjacent to the display driver, wherein the display module includes a display panel and a planarization layer, the display panel including a light-emitting device and an encapsulation structure encapsulating the light-emitting device, and the planarization layer is disposed on the display panel, wherein the first non-bending area includes a display area in which the light-emitting device is disposed and a first peripheral area disposed outside of the display area, and wherein the planarization layer is disposed in the display area and the first peripheral area and overlaps the bending area.

Embodiments may provide a display apparatus, comprising: a display module including a bending area, a first non-bending area, and a second non-bending area, the first non-bending area and the second non-bending area being spaced apart from each other with the bending area interposed therebetween; a display driver disposed in the second non-bending area; a stiffener disposed in the second non-bending area and adjacent to the display driver; an adhesive disposed between the stiffener and the display module; and a bending protection layer disposed in the bending area, wherein the bending protection layer is in contact with the adhesive.

As discussed, in embodiments, a stiffener is disposed in the second non-bending area. The stiffener may be spaced apart from the first non-bending area with the bending area interposed therebetween.

The stiffener may be spaced apart from the display area with the bending area interposed therebetween. The stiffener may be adjacent to the display driver.

The stiffener may be a rigid material.

The stiffener may protect the components of the display apparatus from external stress. For example, the stiffener may include stainless steel. For example, the stiffener may include an alloy of iron and/or chromium.

The display apparatus includes an adhesive for bonding the stiffener to the display module.

The adhesive may be disposed in the second non-bending area. The adhesive may be disposed on a lower surface of the stiffener. The adhesive may be disposed between the stiffener and the display module. According to an embodiment, it is illustrated that the adhesive may be disposed between the stiffener and the display module and the entire adhesive may overlap the stiffener. General adhesives known in the art may be implemented as the adhesive. For example, the adhesive 1100P may include an optically clear adhesive (OCA) or a pressure sensitive adhesive (PSA).

In the display apparatus, according to an embodiment, the planarization layer included in the display module may extend to an area in which the stiffener is disposed, and thus, damage to the display module in the bending area and the non-bending area adjacent to the stiffener may be minimized or prevented. However, the scope of embodiments of the disclosure is not necessarily limited to these effects as described above.

It should be understood that embodiments described herein should be considered in a descriptive sense and not necessarily for purposes of limitation. Descriptions of features or aspects within each embodiment should typically be considered as available for other similar features or aspects in other embodiments. While one or more embodiments have been described with reference to the figures, it will be understood by one of ordinary skill in the art that various changes in form and details may be made therein without departing from the scope of the present disclosure.

## Claims

1. A display apparatus, comprising:
a display module including a bending area, a first non-bending area, and a second non-bending area, the first non-bending area and the second non-bending area being spaced apart from each other with the bending area interposed therebetween;
a display driver disposed in the second non-bending area;
a stiffener disposed in the second non-bending area and adjacent to the display driver; and
an adhesive disposed in the second non-bending area and on a lower surface of the stiffener,
wherein the display module includes a display panel including a display element, a touch unit disposed on the display panel and including a touch electrode and a signal line, and a planarization layer disposed on the touch unit,
wherein the planarization layer is disposed in the first non-bending area and is arranged to extend from the first non-bending area to the second non-bending area.

2. The display apparatus of claim 1, wherein a portion of the planarization layer is disposed in the bending area.

3. The display apparatus of claim 1 or 2, wherein the touch electrode of the touch unit is disposed in the first non-bending area and a portion of the signal line is disposed in the bending area, and
wherein the planarization layer overlaps the portion of the signal line disposed in the bending area.

4. The display apparatus of any one of claims 1 to 3, wherein the first non-bending area includes a display area in which the display element is disposed and a first peripheral area disposed outside of the display area, and
wherein the planarization layer is disposed in the display area and the first peripheral area.

5. The display apparatus of claim 4, wherein the display panel includes:
a first dam portion disposed in the first peripheral area; and
a second dam portion disposed in at least the second non-bending area.

6. The display apparatus of claim 5, wherein a portion of the second dam portion overlaps the stiffener; and/or
wherein the planarization layer is disposed at an inner side of the second dam portion; and/or
wherein the second dam portion is disposed in the first peripheral area, the bending area, and the second non-bending area and is disposed at an outer side of the first dam portion.

7. The display apparatus of claim 5 or 6, wherein the display panel further includes:
a substrate;
a pixel circuit layer disposed on the substrate and including a pixel circuit;
a light-emitting device disposed on the pixel circuit layer; and
an encapsulation structure disposed on the light-emitting device and including at least one inorganic encapsulation layer and at least one organic encapsulation layer,
wherein the at least one organic encapsulation layer is disposed at an inner side of the first dam portion.

8. The display apparatus of any one of claims 1 to 7, wherein the planarization layer overlaps at least a portion of the stiffener; and/or
wherein the planarization layer overlaps at least a portion of the adhesive; and/or
wherein the planarization layer is in contact with a side surface of the adhesive.

9. The display apparatus of any one of claims 1 to 7, further comprising a bending protection layer disposed on the planarization layer in the bending area;
optionally wherein the adhesive is in contact with the bending protection layer.

10. The display apparatus of any one of claims 1 to 8, further comprising a cover disposed on the display driver and the stiffener is disposed in the second non-bending area; and/or
wherein the stiffener surrounds a portion of the display driver, in a plan view.

11. A display apparatus, comprising:
a display module including a bending area, a first non-bending area, and a second non-bending area, the first non-bending area and the second non-bending being spaced apart from each other with the bending area interposed therebetween;
a display driver disposed in the second non-bending area; and
a stiffener disposed in the second non-bending area and adjacent to the display driver,
wherein the display module includes a display panel and a planarization layer, the display panel including a light-emitting device and an encapsulation structure encapsulating the light-emitting device, and the planarization layer is disposed on the display panel,
wherein the first non-bending area includes a display area in which the light-emitting device is disposed and a first peripheral area disposed outside of the display area, and
wherein the planarization layer is disposed in the display area and the first peripheral area and overlaps the bending area.

12. The display apparatus of claim 11, wherein the planarization layer overlaps a portion of the stiffener; and/or
further comprising a bending protection layer disposed on the planarization layer in the bending area; and/or
wherein the display panel includes: a first dam portion disposed in the first peripheral area; and a second dam portion disposed in at least the second non-bending area, optionally wherein a portion of the second dam portion overlaps the stiffener.

13. A display apparatus, comprising:
a display module including a bending area, a first non-bending area, and a second non-bending area, the first non-bending area and the second non-bending area being spaced apart from each other with the bending area interposed therebetween;
a display driver disposed in the second non-bending area;
a stiffener disposed in the second non-bending area and adjacent to the display driver;
an adhesive disposed between the stiffener and the display module; and
a bending protection layer disposed in the bending area,
wherein the bending protection layer is in contact with the adhesive.

14. The display apparatus of claim 13, wherein an area of the adhesive is greater than an area of the stiffener.

15. An electronic device comprising the display apparatus of any one of claims 1 to 14.
